# EUROPEAN PATENT APPLICATION

(11) **EP 3 447 653 A1**
(43) Date of publication of application: **27.02.2019**
(21) Application number: 16899006.7
(22) Date of filing: 22.04.2016
(51) Int. Cl.: G06F 17/16

(54) **SUBMATRIX OPERATION DEVICE AND METHOD**

(71) Applicant: Cambricon Technologies Corporation Limited, Beijing 100190 (CN)
(72) Inventor: LIU, Shaoli, Beijing 100190 (CN); ZHANG, Xiao, Beijing 100190 (CN); CHEN, Yunji, Beijing 100190 (CN); CHEN, Tianshi, Beijing 100190 (CN)
(74) Representative: ABG Intellectual Property Law, S.L.
(86) International application number: PCT/CN2016/080023
(87) International publication number: WO 2017/181419

(57) **Abstract**

The present disclosure provides a sub-matrix operation device and method. The device comprises a storage unit, a register unit and a sub-matrix operation unit. The storage unit stores sub-matrix data. The register unit stores sub-matrix information. The sub-matrix operation unit obtains sub-matrix information from the register unit according to a sub-matrix operation instruction, and then obtains corresponding sub-matrix data from the storage unit according to the sub-matrix information, and then performs sub-matrix operation according to the obtained sub-matrix data, to get a sub-matrix operation result. The present disclosure temporarily stores the sub-matrix data involved in calculation on a high speed scratchpad memory, so that the sub-matrix operation process can support data of different widths more flexibly and effectively, and improve execution performance containing a large number of sub-matrix computing tasks.

## Description

### TECHNICAL FIELD

The present disclosure belongs to a field of computers, and in particular relates to a sub-matrix operation device and method for obtaining sub-matrix data from matrix data according to sub-matrix operation instructions, and performing sub-matrix operations according to the sub-matrix data.

### BACKGROUND

In the current computer field, there are more and more algorithms involving matrix operations, including artificial neural network algorithms and graphic rendering algorithms. At the same time, as an important part of the matrix operation, sub-matrix operations are more and more frequently appearing in various computing tasks. So for those solutions to solve the matrix operation problem, you must consider the efficiency and difficulty of the sub-matrix operation.

A known solution for performing sub-matrix operations in the prior art is to use a general purpose processor. The method performs general purpose instructions through general purpose register files and general functional components, so as to perform sub-matrix operations. However, one of the disadvantages of this method is that a single general purpose processor is mostly used for scalar calculations, and the performance is lower when performing sub-matrix operations. When multiple general purpose processors are used for parallel execution, mutual communication between the general purpose processors may become a performance bottleneck. At the same time, the amount of code for implementing sub-matrix operations is larger than that of normal matrix operations.

In another prior art, a sub-matrix calculation is performed using a graphic processing unit (GPU), in which sub-matrix operations are performed by executing general SIMD instructions using the general purpose register files and the general stream processing unit. However, in the above solution, the GPU on-chip cache is too small, and it is necessary to continuously perform off-chip data transfer when performing large scale sub-matrix operations, and off-chip bandwidth becomes a main performance bottleneck.

In another prior art, sub-matrix calculations are performed using a customized matrix operation device, in which a customized register file and a customized processing unit are used for sub-matrix operations. However, the existing customized matrix operation device is limited by register files and cannot flexibly support sub-matrix operations with different lengths.

In conclusion, the existing graphic processors are unable to perform efficient sub-matrix operations, whether they are on-chip multi-core general purpose processors, inter-chip interconnected general purpose processors (single-core or multi-core), or inter-chip interconnects. These prior art have problems of a large amount of codes, limited by inter-chip communication, insufficient on-chip cache, and unenough flexible scale for supporting sub-matrix when dealing with sub-matrix operations

### SUMMARY

### (1)Technical problems to be solved

The present disclosure provides a sub-matrix operation device and method, which can efficiently implement various sub-matrix operations in cooperation with a sub-matrix operation instruction set.

### (2)Technical solutions

The present disclosure provides a sub-matrix operation device, for obtaining sub-matrix data from matrix data according to a sub-matrix operation instruction, and performing a sub-matrix operation according to the sub-matrix data. The device comprises:
a storage unit for storing matrix data;
a register unit for storing sub-matrix information;
a sub-matrix operation unit, configured to obtain a sub-matrix operation instruction,
and obtains sub-matrix information from the register unit according to the sub-matrix operation instruction, and then obtains sub-matrix data from the matrix data stored in the storage unit according to the sub-matrix information, and then performs sub-matrix operation according to the obtained sub-matrix data, to get a sub-matrix operation result.

The present disclosure also provides a sub-matrix operation method, for obtaining sub-matrix data from matrix data according to a sub-matrix operation instruction, and performing a sub-matrix operation according to the sub-matrix data. The method comprises:
S1, storing matrix data;
S2, storing sub-matrix information;
S3, obtaining a sub-matrix operation instruction, and obtaining sub-matrix information according to the sub-matrix operation instruction, and then obtaining sub-matrix data from the stored matrix data according to the sub-matrix information, and then performing sub-matrix operation according to the obtained sub-matrix data to get a sub-matrix operation result.

### (3) Advantageous effects

The sub-matrix operation device provided by the present disclosure temporarily stores the sub-matrix data involved in calculation on a scratchpad memory, so that the sub-matrix operation process can support data with different widths more flexibly and effectively, and improve execution performance of a large number of matrix computing tasks. The instruction set adopted by the present disclosure is convenient to use, and supports matrix with flexible length.

### BRIEF DESCRIPTION OF THE DRAWINGS

FIG. 1 is a schematic diagram of a sub-matrix operation device provided by the present disclosure.
FIG. 2 is a schematic diagram of a format of an instruction set provided by the present disclosure.
FIG. 3 is a schematic diagram of a sub-matrix of the present disclosure.
FIG. 4 is a schematic diagram of a sub-matrix operation device according to one embodiment of the present disclosure.
FIG. 5 is a flowchart of executing an instruction of sub-matrix multiplying sub-matrix by a sub-matrix operation device according to one embodiment of the present disclosure.
FIG. 6 is a schematic diagram of matrix data and sub-matrix data according to one embodiment of the present disclosure.
FIG. 7 is a flowchart of performing a convolutional neural network operation by a sub-matrix operation device according to one embodiment of the present disclosure.

### EXAMPLES

The present disclosure provides a sub-matrix operation device and method, including a storage unit, a register unit, and a sub-matrix operation unit. The storage unit stores sub-matrix data. The register unit stores sub-matrix information. The sub-matrix operation unit obtains sub-matrix information from the register unit according to a sub-matrix operation instruction, and then obtains corresponding sub-matrix data from the storage unit according to the sub-matrix information, and then performs sub-matrix operation according to the obtained sub-matrix data, to get a sub-matrix operation result. The present disclosure temporarily stores the sub-matrix data involved in calculation on a scratchpad memory, so that the sub-matrix operation process can support data with different widths more flexibly and effectively, and improve execution performance containing a large number of sub-matrix computing tasks. The scratchpad memory can be implemented by various memory devices (such as a static random access memory (SRAM), an enhanced dynamic random access memory (eDRAM), a dynamic random access memory (DRAM), a memristor, a 3D-DRAM, a non-transitory memory, or the like).

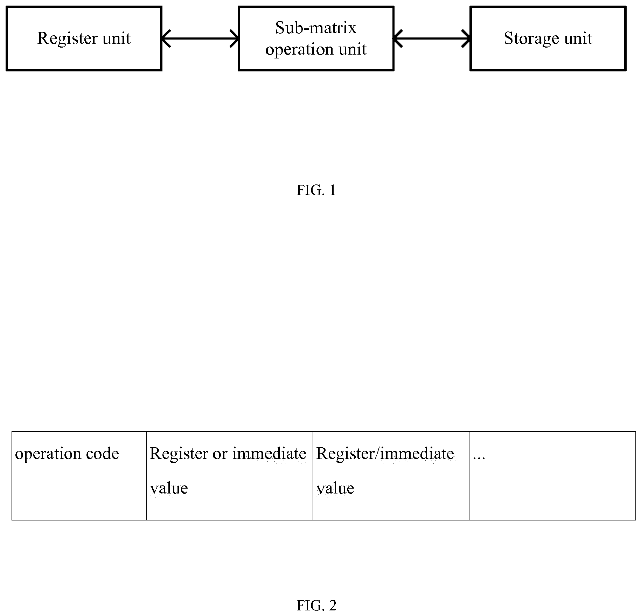

FIG. 1 is a schematic diagram of a sub-matrix operation device provided by the present disclosure. As shown in FIG. 1, the device includes:
a storage unit for storing matrix data;
a register unit for storing sub-matrix information; in a specific application, a register file may be composed of a plurality of register units, and each register unit stores different sub-matrix information, it should be noted that the sub-matrix information is scalar data;
a sub-matrix operation unit, configured to obtain a sub-matrix operation instruction, and obtains sub-matrix information from the register unit according to the sub-matrix operation instruction, and then obtains sub-matrix data from the matrix data stored in the storage unit according to the sub-matrix information, and then performs sub-matrix operation according to the obtained sub-matrix data, to get a sub-matrix operation result.

FIG. 2 is a schematic diagram of a format of an instruction set provided by the present disclosure. As shown in FIG. 2, the instruction set adopts a Load/Store structure, and the sub-matrix operation unit does not operate on data in the memory. The sub-matrix instruction set uses a Very Long Instruction Word architecture. At the same time, the instruction set uses fixed length instructions, so that the sub-matrix operation device can take a value of next sub-matrix operation instruction during a decoding stage of previous sub-matrix operation instruction. The sub-matrix operation instruction includes an operation code and a plurality of operation fields. Therein, the operation code is configured to indicate a function of the sub-matrix operation instruction. The operation field is configured to indicate the data information of the sub-matrix operation instruction. The data information is the serial number or the immediate value of the register unit. The sub-matrix operation unit accesses a corresponding register unit according to the serial number of the register unit, to obtain the sub-matrix information. Or, the sub-matrix operation unit can directly perform the sub-matrix operation on the immediate data as the sub-matrix data.

It should be noted that the operation code of the operation instruction for different functions is also different. Specifically, in the instruction set provided by the present disclosure, the sub-matrix operation instruction with different functions is included:

A sub-matrix multiply vector instruction (SMMV), according to which the device obtains a specified sub-matrix data from a specified address of the scratchpad memory according to a start address, a row width, a column width and a row interval of the sub-matrix in the instruction, and extracts vector data at the same time. The device performs multiplication of the matrix multiplication vector in the operation unit and writes the result back to the specified address of the scratchpad memory. It is worth noting that the vector can be stored as a special form matrix (a matrix of only one row of elements) in the scratchpad memory.

A vector multiply sub-matrix instruction (VMSM), according to which the device obtains the vector data from the specified address of the scratchpad memory, and obtains the specified sub-matrix according to the start address of the sub-matrix, the row width and the column width of the sub-matrix, and the row interval of the sub-matrix in the instruction. The device performs multiplication of vector multiplying sub-matrix in the matrix unit and writes the result back to the specified address of the scratchpad memory. It is worth noting that the vector can be stored as a special form matrix (a matrix of only one row of elements) in the scratchpad memory.

A sub-matrix multiply scalar instruction (SMMS), according to which the device obtains the specified sub-matrix data from the specified address of the scratchpad memory according to the row width and column width of the sub-matrix and the row interval of the sub-matrix in the instruction. The device obtains specified scalar data from the specified address of the scalar register file. The device performs operations of the sub-matrix multiply scalar in the matrix operation unit, and writes the result back to the specified address of the scratchpad memory. It should be noted that the scalar register file not only stores various data information of sub-matrix (including start address, row width, column width, and row interval), but also contains the scalar data itself.

A tensor operation instruction (TENS), according to which the device obtains the two specified pieces of sub-matrix data from the scratchpad memory, performs tensor operation on the two sub-matrix data in the matrix operation unit, and writes the calculation result back to the specified address of the scratchpad memory.

A sub-matrix addition instruction (SMA), according to which the device obtains the two specified sub-matrix data from the scratchpad memory, performs an addition operation on the two sub-matrix data in the matrix operation unit, and writes the calculation result back to the specified address of the scratchpad memory.

A sub-matrix subtraction instruction (SMS), according to which the device obtains the two specified sub-matrix data from the scratchpad memory, performs a subtraction operation on the two sub-matrix data in the matrix operation unit, and writes the calculation result back to the specified address of the scratchpad memory.

A sub-matrix multiplication instruction (SMM), according to which the device obtains the two specified pieces of sub-matrix data from the scratchpad memory, performs a bitwise multiplication operation on the two sub-matrix data in the matrix operation unit, and writes the calculation result back to the specified address of the scratchpad memory.

A convolutional instruction (CONV) according to which the convolution kernel is implemented to perform convolution filtering for the matrix. The device obtains the specified convolution kernel matrix from the scratchpad memory, and starts to filter the sub-matrix data covered by the convolution kernel at the current position starting from the starting address where stores the matrix to be convolved, that is, performs a bitwise multiplication operation of the convolution kernel with sub-matrix in the matrix operation unit, and sums the obtained matrix to obtain the filtering result of the current position, and writes the result back to the specified address of the scratchpad memory. Then, according to the displacement parameter given in the instruction, the convolution kernel is moved to the next position on the matrix to be convolved, and the above operation is repeated until it moves to the end position.

A sub-matrix move instruction (SMMOVE), according to which the device stores the specified sub-matrix stored in the scratchpad memory to another address of the scratchpad memory.

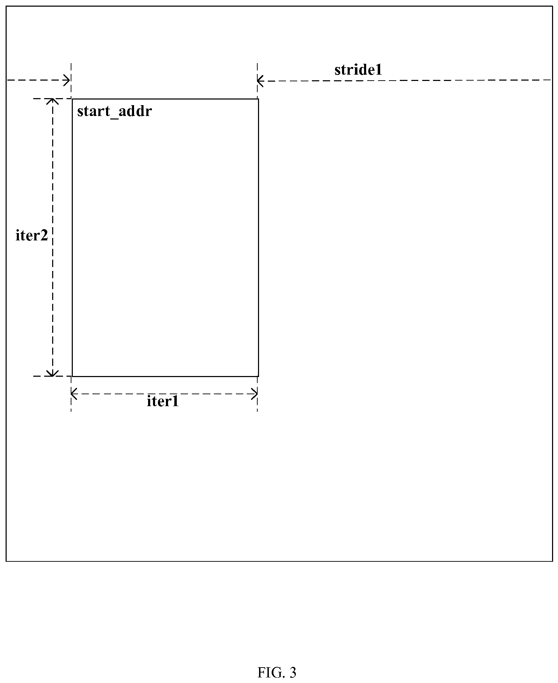

In addition, the sub-matrix information stored in the register unit includes a start address (start_addr) of the sub-matrix data in the storage unit, a row width (iter1) of the sub-matrix data, a column width (iter2) of the sub-matrix data, and a row interval (stride 1). Therein, the row interval refers to a data interval between an end of previous row of the sub-matrix data and a beginning of next row of the sub-matrix data in two adjacent rows of the sub-matrix data. As shown in FIG. 3, the matrix data is actually stored in a one-dimensional manner in the storage unit. The starting address of the sub-matrix is the address of the element in the upper left corner of the sub-matrix in FIG. 3. The row width of the sub-matrix is the number of elements in each row of the sub-matrix as shown in FIG. 3. The column width of sub-matrix is the number of elements in each column of the sub-matrix as shown in FIG. 3. The row interval of the sub-matrix is the address interval between the last element of the previous row of sub-matrix and the first element of the next row as shown in FIG. 3. Then, when the device actually reads the sub-matrix data, it only needs to start from the start_addr. After reading the iter1 data, skip the stride1 data and read the iter1 data again, and repeat the iter2 times to obtain the complete sub-matrix data.

Furthermore, the sub-matrix operation device further includes an instruction processing unit, configured to obtain the sub-matrix operation instruction, and process the sub-matrix operation instruction, and provide the processed sub-matrix operation instruction to the sub-matrix operation unit. In detail, the instruction processing unit includes an instruction fetching module, a decoding module, an instruction queue, and a dependency processing unit. Therein, the instruction fetching module obtains the sub-matrix operation instruction. The decoding module decodes the obtained sub-matrix operation instruction. The instruction queue sequentially stores the decoded sub-matrix operation instructions. The dependency processing unit determines whether the sub-matrix operation instruction and a previous sub-matrix operation instruction access a same sub-matrix data before the sub-matrix operation unit obtains the sub-matrix operation instruction, and if yes, stores the sub-matrix operation instruction in a storage queue, and provides the sub-matrix operation instruction in the storage queue to the sub-matrix operation unit after waiting for execution of the previous sub-matrix operation instruction, otherwise, directly provides the sub-matrix operation instruction to the sub-matrix operation unit.

Furthermore, the storage unit is further configured to store the sub-matrix operation result. Preferably, the scratchpad memory can be configured as the storage unit. In addition, the present disclosure further includes an input and output unit, directly coupled to the storage unit, and the input and output unit is configured for storing the matrix data in the storage unit, or obtaining the sub-matrix operation result from the storage unit.

Furthermore, the sub-matrix operation unit includes a sub-matrix addition part, a sub-matrix multiplication part, a size comparison part, a nonlinear operation part, and a sub-matrix scalar multiplication part. Moreover, the sub-matrix operation unit is a multi-flow level structure, and the multi-flow level structure includes a first flow level, a second flow level, and a third flow level. Therein, the sub-matrix addition part and the sub-matrix multiplication part are at the first flow level, the size comparison part is at the second flow level, and the nonlinear operation part and the sub-matrix scalar multiplication part are at the third flow level.

The present disclosure also provides a sub-matrix operation method, including:
S1, storing matrix data;
S2, storing sub-matrix information;
S3, obtaining a sub-matrix operation instruction, and obtaining sub-matrix information according to the sub-matrix operation instruction, and then obtaining sub-matrix data from the stored matrix data according to the sub-matrix information, and then performing sub-matrix operation according to the obtained sub-matrix data to get a sub-matrix operation result.

Furthermore, before step S3, the method further includes:
obtaining the sub-matrix operation instruction;
decoding the obtained sub-matrix operation instruction;
determining whether the sub-matrix operation instruction and a previous sub-matrix operation instruction access a same sub-matrix data, and if yes, storing the sub-matrix operation instruction in a storage queue, and waiting for an execution of the previous sub-matrix operation instruction, and then executing the step S3, otherwise, executing the step S3 directly.

Furthermore, step S3 further includes: storing the sub-matrix operation result.

Furthermore, the method further includes: step S4, obtaining the stored sub-matrix operation result.

Furthermore, the sub-matrix operation includes a sub-matrix addition operation, a sub-matrix multiplication operation, a size comparison operation, a nonlinear operation, and a sub-matrix scalar multiplication operation. Moreover, a multi-flow level structure is used to perform a sub-matrix operation. The multi-flow level structure includes a first flow level, a second flow level, and a third flow level. Therein, the sub-matrix addition operation and the sub-matrix multiplication operation are performed at the first flow level, the size comparison operation is performed at the second flow level, and the nonlinear operation and the sub-matrix scalar multiplication operation are performed at the third flow level.

In order to make the objects, technical solutions and advantages of the present disclosure clearer, the present disclosure will be further described in detail below with reference to the specific embodiments and the accompanying drawings.

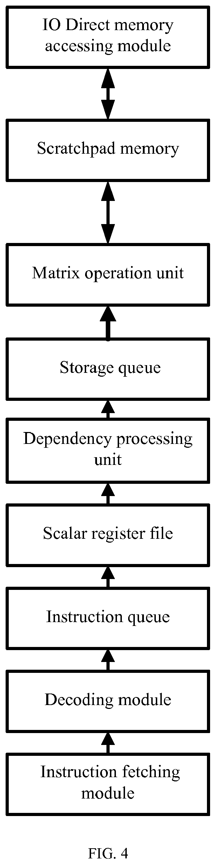

FIG. 4 is a schematic diagram of a sub-matrix operation device according to one embodiment of the present disclosure. As shown in FIG. 4, the device includes an instruction fetching module, a decoding module, an instruction queue, a scalar register file, a dependency processing unit, a storage queue, a matrix operation unit, and a scratchpad memory, an IO memory accessing module, where:
the instruction fetching module, which is responsible for fetching a next instruction to be executed from the instruction sequence and providing the instruction to the decoding module;
the decoding module, which is responsible for decoding the instruction, and providing the decoded instruction to the instruction queue;
the instruction queue, considering that different instructions may have dependencies on the contained scalar registers, for buffering the decoded instructions, and transmitting the instructions when the dependencies are satisfied;
the scalar register file that provides multiple scalar registers required by the device during the operation;
the dependency processing unit that processes the storage dependencies that an instruction may have with the previous instruction, the matrix operation instruction accesses the scratchpad memory, and the previous and next instructions may access the same block of memory. In order to ensure the correctness of the execution result of the instruction, if the current instruction is detected to have a dependency on the data of the previous instruction, the instruction must wait in the storage queue until the dependency is eliminated.
the storage queue, which is an ordered queue, and the instructions related to the previous instructions on the data are stored in the queue until the storage relationship is eliminated;
the matrix operation unit, which is responsible for all the sub-matrix operations of the device. The sub-matrix operations includes but not limited to sub-matrix addition operations, sub-matrix add scalar operations, sub-matrix subtraction operations, sub-matrix subtract scalar operations, sub-matrix multiplication operations, sub-matrix multiply scalar operations, sub-matrix divisions (bitwise division) operations, sub-matrix and operation and sub-matrix or operation. The sub-matrix operation instructions are transmitted to the operation unit to execute;
the scratchpad memory, which is a temporary storage device dedicated to matrix data, and can support matrix data with different sizes;
the IO memory accessing module, which is configured to directly access the scratchpad memory and is responsible for reading data or writing data from the scratchpad memory.

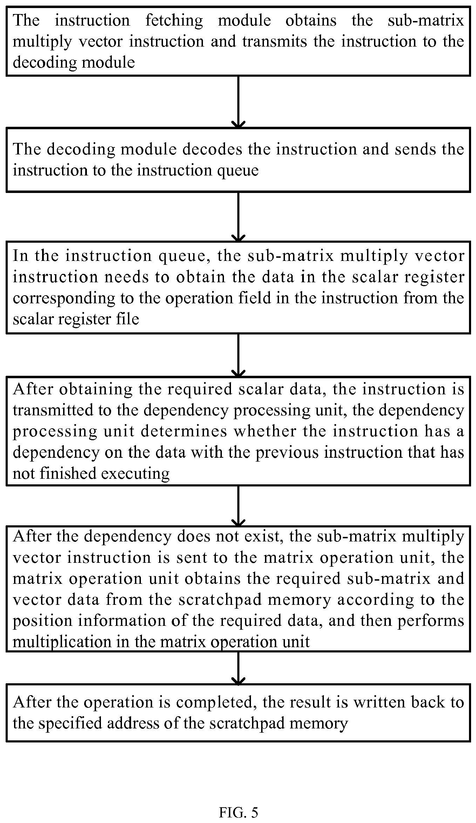

FIG. 5 is a flowchart of executing sub-matrix multiply vector by a sub-matrix operation device according to one embodiment of the present disclosure. As shown in FIG. 5, the process of executing the instruction of sub-matrix multiply vector includes:
S1, the instruction fetching module obtains the sub-matrix multiply vector instruction and transmits the instruction to the decoding module.
S2, the decoding module decodes the instruction and sends the instruction to the instruction queue.
S3, in the instruction queue, the sub-matrix multiply vector instruction needs to obtain the data in the scalar register corresponding to the operation field in the instruction from the scalar register file, the data includes an input vector address, an input vector length, an input sub-matrix address, an input sub-matrix row width, an input sub-matrix column width, an input sub-matrix row interval, an output vector address, and an output vector length.
S4, after obtaining the required scalar data, the instruction is transmitted to the dependency processing unit, the dependency processing unit determines whether the instruction has a dependency on the data with the previous instruction that has not finished executing. The instruction needs to wait in the store queue until it no longer has a dependency on the data with the previous instruction that has not finished executing.
S5, after the dependency does not exist, the sub-matrix multiply vector instruction is sent to the matrix operation unit. The matrix operation unit obtains the required sub-matrix and vector data from the scratchpad memory according to the position information of the required data, and then performs multiplication in the matrix operation unit.
S6, after the operation is completed, the result is written back to the specified address of the scratchpad memory.

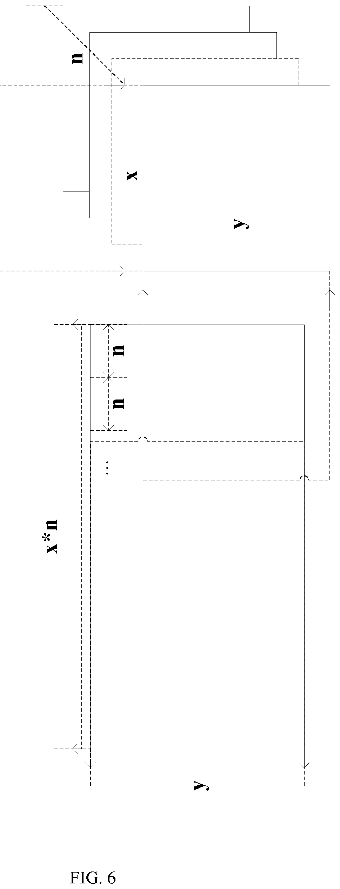

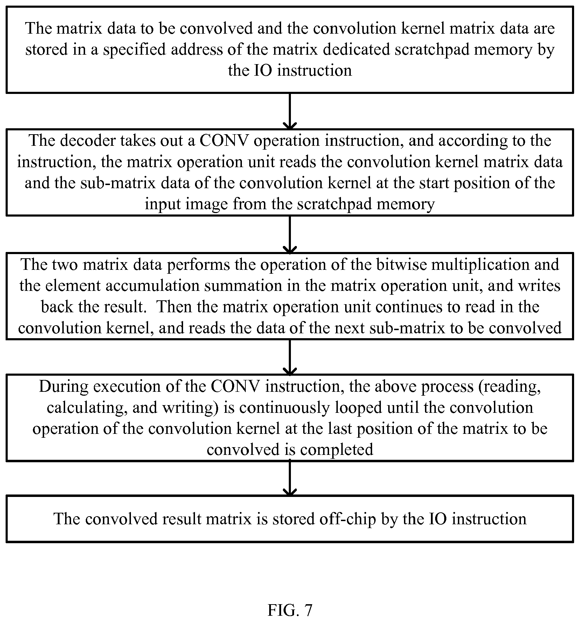

FIG. 6 is a flowchart of performing a convolutional neural network operation by a sub-matrix operation device according to one embodiment of the present disclosure. The method is mainly implemented by sub-matrix operation instructions. The operational characteristics of the convolutional neural network are: for feature image input (where n is the number of input feature images, y is the feature image length, x is the feature image width) having an n×y×x scale, and they have an n×h×w scale of the convolution kernel. The convolution kernel constantly moves on the input image, and the convolution kernel is used to perform convolution operation with the data of the input image covered by itself at each position to obtain a value of a corresponding point on the output image. For this computational feature, the convolutional neural network can be implemented by a sub-matrix convolutional instruction loop. In the actual storage, as shown in FIG. 6, the data is expanded in the dimension of the number of images, and the input data image is changed from a three-dimensional array of n×y×x to a two-dimensional matrix of y×(x×n). Similarly, the convolution kernel data becomes a two-dimensional matrix of h×(w×n). As shown in FIG. 7, the process of implementing the convolutional neural network includes:
S1, the matrix data to be convolved and the convolution kernel matrix data stores in a specified address of the matrix dedicated scratchpad memory by the IO instruction.
S2, the decoder takes out a CONV operation instruction, and according to the instruction, the matrix operation unit reads the convolution kernel matrix data and the sub-matrix data of the convolution kernel at the start position of the input image from the scratchpad memory.
S3, the two matrix data performs the operation of the bitwise multiplication and the element accumulation summation in the matrix operation unit, and writes back the result. Then the matrix operation unit continues to read in the convolution kernel, and reads the data according to the starting address of the next sub-matrix to be convolved, therein the starting address is obtained from the displacement parameter in the instruction.
S4, during the execution of the CONV instruction, the above process continues to loop until the convolution operation of the convolution kernel at the last position of the matrix to be convolved is completed.
S5, the convolved result matrix is stored off-chip by the IO instruction.

It should be noted that this embodiment adopts a more efficient method to implement convolution operation, that is, the three-dimensional input image and the convolution kernel are both expanded into a two-dimensional form. In fact, this is not the only way of the device and method of the present disclosure to implement convolution operation. A more general method is to perform a convolution operation on each of the two-dimensional images of the input and the corresponding convolution kernel through a sub-matrix instruction to obtain a partial and final convolution result of the output. It is the cumulative sum of the partial sums of all the two-dimensional images and the convolution operations of the corresponding convolution kernels. Therefore, sub-matrix operation instructions can implement convolution operations in a variety of ways.

In conclusion, the present disclosure provides a matrix operation device, and cooperates with the corresponding sub-matrix operation instruction set, which can well solve the problem that more and more algorithms in the current computer field contain a large number of sub-matrix operations. Compared with the existing conventional solutions, the solution can have the advantages of convenient use, support of flexible sub-matrix scale, and sufficient on-chip buffering. The present disclosure can be applied to a variety of computational tasks involving a large number of sub-matrix operations, including reverse training and forward prediction of artificial neural network algorithms that currently perform well.

The specific embodiments of the present disclosure have been described in detail, and are not intended to limit the present disclosure. Any modifications, equivalent substitutions, improvements, etc., made within the spirit and scope of the invention are intended to be included within the scope of the invention.

## Claims

1. A sub-matrix operation device, for obtaining sub-matrix data from matrix data according to a sub-matrix operation instruction, and performing a sub-matrix operation according to the sub-matrix data, wherein the device comprises:
a storage unit for storing matrix data;
a register unit for storing sub-matrix information;
a sub-matrix operation unit, configured to obtain a sub-matrix operation instruction, and obtains sub-matrix information from the register unit according to the sub-matrix operation instruction, and then obtains sub-matrix data from the matrix data stored in the storage unit according to the sub-matrix information, and then performs sub-matrix operation according to the obtained sub-matrix data, to get a sub-matrix operation result.

2. The sub-matrix operation device according to claim 1, wherein the sub-matrix operation instruction comprises an operation code and at least one operation field, wherein the operation code is configured to indicate a function of the sub-matrix operation instruction, the operation field is configured to indicate data information of the sub-matrix operation instruction.

3. The sub-matrix operation device according to claim 2, wherein the data information is a serial number of the register unit, and the sub-matrix operation unit accesses a corresponding register unit according to the serial number of the register unit, to obtain the sub-matrix information.

4. The sub-matrix operation device according to claim 1, wherein the sub-matrix information comprises a start address of the sub-matrix data, a row width of the sub-matrix data, a column width of the sub-matrix data, and a row interval of the sub-matrix data in the storage unit, wherein, the row interval refers to a data interval between an end of previous row of the sub-matrix data and a beginning of next row of the sub-matrix data in two adjacent rows of the sub-matrix data.

5. The sub-matrix operation device of claim 1, further comprising:
an instruction processing unit, configured to obtain the sub-matrix operation instruction,
and process the sub-matrix operation instruction, and provide the processed sub-matrix operation instruction to the sub-matrix operation unit.

6. The sub-matrix operation device according to claim 5, wherein the instruction processing unit comprises:
an instruction fetching module, configured for fetching the sub-matrix operation instruction;
a decoding module, configured to decode the obtained sub-matrix operation instruction;
an instruction queue, configured for sequentially storing the decoded sub-matrix operation instructions;
a dependency processing unit, configured to determine whether the sub-matrix operation instruction and a previous sub-matrix operation instruction access a same sub-matrix data before the sub-matrix operation unit obtains the sub-matrix operation instruction, and if yes, stores the sub-matrix operation instruction in a storage queue, and provides the sub-matrix operation instruction in the storage queue to the sub-matrix operation unit after waiting for execution of the previous sub-matrix operation instruction, otherwise, directly provides the sub-matrix operation instruction to the sub-matrix operation unit.

7. The sub-matrix operation device according to claim 1, wherein the storage unit is further configured to store the sub-matrix operation result.

8. The sub-matrix operation device of claim 7, further comprising:
an input and output unit, configured to store the matrix data in the storage unit, or obtain the sub-matrix operation result from the storage unit.

9. The sub-matrix operation device of claim 1, wherein the storage unit is a scratchpad memory.

10. The sub-matrix operation device according to claim 1, wherein the sub-matrix operation unit comprises a sub-matrix addition part, a sub-matrix multiplication part, a size comparison part, a nonlinear operation part, and a sub-matrix scalar multiplication part.

11. The sub-matrix operation device according to claim 10, wherein the sub-matrix operation unit is a multi-flow level structure, and the multi-flow level structure comprises a first flow level, a second flow level, and a third flow level, wherein the sub-matrix addition part and the sub-matrix multiplication part are at the first flow level, the size comparison part is at the second flow level, and the nonlinear operation part and the sub-matrix scalar multiplication part are at the third flow level.

12. A sub-matrix operation method, for obtaining sub-matrix data from matrix data according to a sub-matrix operation instruction, and performing a sub-matrix operation according to the sub-matrix data, wherein the method comprises:
S1, storing matrix data;
S2, storing sub-matrix information;
S3, obtaining a sub-matrix operation instruction, and obtaining sub-matrix information according to the sub-matrix operation instruction, and then obtaining sub-matrix data from the stored matrix data according to the sub-matrix information, and then performing sub-matrix operation according to the obtained sub-matrix data to get a sub-matrix operation result.

13. The sub-matrix operation method according to claim 12, wherein the sub-matrix operation instruction comprises an operation code and at least one operation field, wherein the operation code is configured to indicate a function of the sub-matrix operation instruction, the operation field is configured to indicate data information of the sub-matrix operation instruction.

14. The sub-matrix operation method according to claim 12, wherein the sub-matrix information comprises a start address of the sub-matrix data, a row width of the sub-matrix data, a column width of the sub-matrix data, and a row interval of the sub-matrix data in the storage unit, wherein, the row interval refers to a data interval between an end of previous row of the sub-matrix data and a beginning of next row of the sub-matrix data in two adjacent rows of the sub-matrix data.

15. The sub-matrix operation method according to claim 12, wherein, before the step S3, the method further comprises:
obtaining the sub-matrix operation instruction;
decoding the obtained sub-matrix operation instruction;
determining whether the sub-matrix operation instruction and a previous sub-matrix operation instruction access a same sub-matrix data, and if yes, storing the sub-matrix operation instruction in a storage queue, and waiting for an execution of the previous sub-matrix operation instruction, and then executing the step S3, otherwise, executing the step S3 directly.

16. The sub-matrix operation method according to claim 12, wherein the step S3 further comprises: storing the sub-matrix operation result.

17. The sub-matrix operation method according to claim 16, wherein, the method further comprises: step S4, obtaining the stored sub-matrix operation result.

18. The sub-matrix operation method according to claim 12, wherein the sub-matrix operation comprises a sub-matrix addition operation, a sub-matrix multiplication operation, a size comparison operation, a nonlinear operation, and a sub-matrix scalar multiplication operation.

19. The sub-matrix operation method according to claim 18, wherein a multi-flow level structure is used to perform a sub-matrix operation, wherein the multi-flow level structure comprises a first flow level, a second flow level, and a third flow level, wherein the sub-matrix addition operation and the sub-matrix multiplication operation are performed at the first flow level, the size comparison operation is performed at the second flow level, and the nonlinear operation and the sub-matrix scalar multiplication operation are performed at the third flow level.
